# EUROPEAN PATENT APPLICATION

(11) **EP 1 626 615 A1**
(43) Date of publication of application: **15.02.2006**
(21) Application number: 04732012.2
(22) Date of filing: 10.05.2004
(51) Int. Cl.: H05K 3/46

(54) **FLEXIBLE CIRCUIT BOARD, METHOD FOR MAKING THE SAME, FLEXIBLE MULTI-LAYER WIRING CIRCUIT BOARD, AND METHOD FOR MAKING THE SAME**

(30) Priority: 12.05.2003 JP 2003133005
(71) Applicant: North Corporation, Tokyo 170-0005 (JP); SONY CHEMICALS CORP., Tokyo 141-0032 (JP)
(72) Inventor: IIJIMA, Tomoo, Toshima-ku, Tokyo 1700005 (JP); OSAWA, Kenji, Toshima-ku, Tokyo 1700005 (JP); ENDO, Kimitaka, Toshima-ku, Tokyo 1700005 (JP); ECHIGO, Yoshiaki, 6110021 (JP); SHIGETA, Akira, Uji-shi, Kyoto (JP); KOBAYASHI, Kazuyoshi, c/o SONY CHEMICALS. CORP., Kanuma-shi, Tochigi 322-8502 (JP); HANAMURA, Kenichiro, Kanuma-shi, Tochigi 322-8502 (JP)
(74) Representative: Vossius & Partner
(86) International application number: PCT/JP2004/006248
(87) International publication number: WO 2004/100630

(57) **Abstract**

There is provided a flexible circuit board 22 that, when deposited on another flexible circuit board 40, causes no gap to occur between wiring films 4a, 4a, of the flexible circuit board 40. Moreover, a plurality of flexible circuit boards are deposited on one another to provide a flexible multi-layer wiring circuit board having no gaps between the flexible circuit boards and having less bowing. In the flexible circuit board 22, the thickness of a bonding layer 16, 16a, on the opposed side of a bowing metallic member 2, of an inter-layer insulating film 10 where which bumps 6 are formed is greater than the thickness of a bonding layer on the side of metallic member 2. When the flexible circuit board 22 is deposited on the other flexible circuit board 40 to form a flexible multi-layer wiring circuit board 50, the bonding layer 16, 16a can be filled between the wiring films 4a, 4a, so that the flexible multi-layer wiring circuit board 50 has no gaps and a less bowing.

## Description

### TECHNICAL FIELD

The present invention relates to a flexible circuit board used for a flexible multi-layer wiring circuit boardon which an electronic device such as an IC or LSI is mounted and a method of manufacturing the same, and a flexible multi-layer wiring circuit board using the flexible multi-layer wiring circuit board and a method of manufacturing the same.

### BACKGROUND ART

The applicant of the application concerned developed as a technique for manufacturing a flexible multi-layer wiring circuit board, a technique for processing, as a base, a metal member having a three-layer structure in which an etching barrier layer (for example, 1 µm in thickness) made of nickel or the like is formed on a main surface of a copper layer for bump formation (for example, 100 µm in thickness) by plating or the like and a copper foil for conductor circuit formation (for example, 18 µm in thickness) is formed on an upper surface of the etching barrier layer, to produce a wiring circuit board having a large number of interlayer connecting bumps, and connecting it to another wiring circuit board to obtain the flexible multi-layer wiring circuit board. The developed technique is proposed in an application of, for example, Japanese Patent Application No. 2000-230142 (JP 2002-43506 A) or Japanese Patent ApplicationNo. 2002-66410. The metal member having the three-layer structure can also be formed by rolling three metal plates which are laminated.

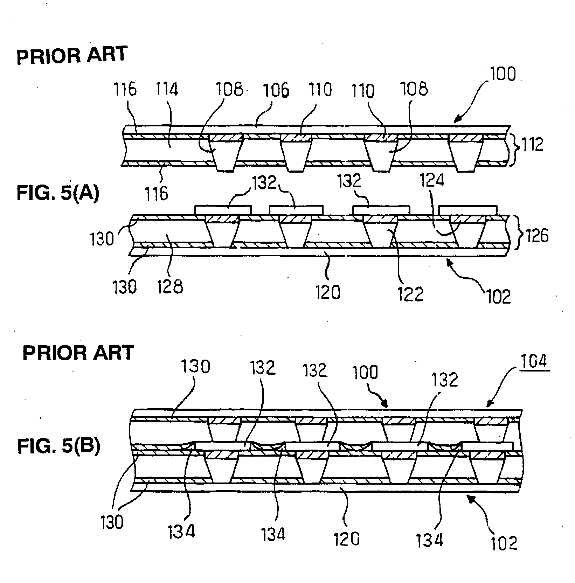

Figs. 5 (A) and 5 (B) are sectional views showing a process for connecting the wiring circuit board having the interlayer connecting bumps to the other wiring circuit board in order. This process will be described. First, as shown in Fig. 5(A), two flexible circuit boards 100 and 102 are opposed to each other such that main surfaces of those face each other.

Reference numeral 106 denotes a copper layer composing the one flexible circuit board 100. A large number of bumps 108 are formed above a main surface of the copper layer 106. Reference numeral 110 denotes an etching barrier layer which is made of, for example, nickel and interposed between a base portion of each of the bumps 108 and the copper layer 106. The etching barrier layer is formed to prevent the copper layer 106 from etching when a copper layer for bump formation which is formed above the copper layer 106 is to be selectively etched to form the bumps. After the selective etching, the etching barrier layer 110 is not etched using each of the bumps 108 as a mask, so a portion thereof is left below the base portion of each of the bumps 108.

Reference numeral 112 denotes an interlayer insulating film in which thin bonding material layers 116, 116 are formed on both surfaces of a non-thermoplastic polyimide layer 114 corresponding to the core of the film. The one bonding material layer 116 is used for bonding the interlayer insulating film 112 to the copper layer 106. The other bonding material layer 116 is used for bonding the interlayer insulating film 112 to the other flexible circuit board 102. Each of the bonding material layers 116, 116 is made of a thermoplastic polyimide resin layer.

Reference numeral 120 denotes a copper layer for the other flexible circuit board 102, 122 denotes bumps formed on a main surface of the copper layer 120, and 124 denotes an etching barrier layer formed on a base portion of each of the bumps 122. Reference numeral 126 denotes an interlayer insulating film in which thermoplastic polyimide layers 130, 130 as bonding layers to which copper foils are bonded are formed on and under a non-thermoplastic polyimide resin layer 128. Reference numeral 132 denotes wiring films formed on the interlayer insulating film 126. At least a part of each of the wiring films 132 is connected to an upper surface of each of the bumps 122 of the one flexible circuit board 100.

Next, as shown in Fig. 5(B), the flexible circuit board 100 is aligned with the flexible circuit board 102 such that the upper surface of each of the bumps 108 of the flexible circuit board 102 is fit to each of the wiring films 132 corresponding to the bumps 108, of the flexible circuit board 102. Then, pressurization and heating are performed for lamination such that the thermoplastic polyimide resin layer 116 is allowed to flow between the wiring films 132. Therefore, the two flexible circuit boards 100 and 102 are integrally formed with each other to obtain a flexible multi-layer wiring circuit board 104.

The conventional flexible multi-layer wiring circuit board 104 has a problem in that a gap 134 is caused between the respective wiring films 132 of the second flexible circuit board 102. The gap 134 is a kind of void, so that it causes delamination, water penetrates through it, or copper migration occurs at the time of voltage application. As a result, the gap causes a loss of function as the board. Further, when the wiring films 132 are presumed to be located in the center of the flexible multi-layer wiring circuit board 104 in a thickness direction thereof, there is a disadvantage that the warped flexible multi-layer wiring circuit board 104 is obtained because a layer structure in the up-and-down direction does not become symmetric (axisymmetric).

Therefore, the inventors of the application concerned examined a cause of the gap 134. As a result, it is found that the mass of thermoplastic polyimide resin as bonding material is not enough to fill a space between circuit patterns, that is, between the wiring films 132, 132 because the bonding material layers (thermoplastic resin layer)116 is thin.
In other words, the bonding material layers 116 formed on both surfaces of the interlayer insulating film 112 of the first flexible circuit board 100 have the same thickness which is, for example, about 5 µm. This thickness is a thickness sufficient to bond the non-thermoplastic polyimide resin layer 114 of the interlayer insulating film 112 to a bump formation surface of the copper layer 106. However, when the non-thermoplastic polyimide resin layer 114 is to be bonded to the other flexible circuit board 102 side, the above-mentioned thickness is insufficient to fill a space between the respective wire films 132, 132, that is, between the circuit patterns. As a result, it is found that the space between the wire films 132, 132 cannot be filled with only the bonding material layer 116 flowing thereinto, thereby causing the gap 134. This causes inconvenience that the completed flexible circuit board is warped.

That is, when the wiring films 132 are presumed to be located in the center of the flexible multi-layer wiring circuit board 104 in the thickness direction thereof, the layer structure in the up-and-down direction does not become symmetric (axisymmetric), because of the presence of the gap 134. As a result, the flexible multi-layer wiring circuit board 104 is obtained in a warped form.

The present invention has been made to solve such problems. An object of the present invention is to provide a flexible circuit board in which a gap can be prevented from being caused between wiring films when another flexible circuit board is laminated thereon. Another object of the present invention is to provide a flexible multi-layer wiring circuit board in which a plurality of flexible circuit boards are laminated while a gap is prevented from being caused therebetween. Still another object of the present invention is to provide a flexible multi-layer wiring circuit board which is not warped by the gap.

Patent Document 1: JP 2002-43506 A
Patent Document 2: JP 2002-66410 A

### DISCLOSURE OF THE INVENTION

A flexible circuit board according to claim 1 is characterized by including: a plurality of bumps which are directly formed on a surface portion of one of a wiring layer and a metal layer for wiring layer formation or formed thereon through an etching barrier layer, each of the bumps having an upper surface connected to a wiring film of another flexible circuit board; and an interlayer insulating film including a non-thermoplastic polyimide layer and thermoplastic polyimide layers as bonding agents which are formed on both surface thereof, the interlayer insulating film being provided in a portion in which the bumps are not formed on a bump formation surface of the one of the wiring layer and the metal layer for wiring layer formation, wherein one of the thermoplastic polyimide layers of the interlayer insulating film which is located on an opposed side of the one of the wiring layer and the metal layer for wiring layer formation is thicker than the other of the thermoplastic polyimide layers.

A method of manufacturing a flexible circuit board according to claim 2 is characterized by including: preparing one of a wiring layer and a metal layer for wiring layer formation in which a plurality of bumps are directly formed on a surface portion thereof or formed thereon through an etching barrier layer; andpressurization-bonding under pressure and heating, an interlayer insulating film in which thermoplastic polyimide layers as bonding agents which have thicknesses different from each other and are formed on both surface of a non-thermoplastic polyimide layer to a bump formation surface of the one of the wiring layer and the metal layer for wiring layer formation such that each of the bumps passes through the interlayer insulating film in a direction in which a thinner thermoplastic polyimide layer faces the bump formation surface.

A flexible multi-layer wiring circuit board according to claim 3 is characterized by including: a flexible circuit board in which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers; and an another flexible circuit board different from the flexible circuit board, in which wiring layers are formed on at least one main surface, at least a part of each of the wiring layers is connected to an upper surface of each of the bumps, and a space between the wiring layers on the one main surface is filled with a thicker thermoplastic polyimide layer molten.

A method of manufacturing a flexible multi-layer wiring circuit board according to claim 4 is characterized by including: preparing: a first flexible circuit board, in which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers; and a second flexible circuit board in which wiring layers thinner than the thicker thermoplastic polyimide layer are formed on at least one main surface thereof; and performing heating-pressurization processing for connecting the wiring layers formed on the both surfaces of the second flexible circuit board to upper surfaces of the bumps of the two first flexible circuit boards and filling a space between the wiring layers of the second flexible circuit board with a thicker thermoplastic polyimide layer molten of the first flexible circuit board.

A method of manufacturing a flexible multi-layer wiring circuit board according to claim 5 is characterized by including: preparing: two first flexible circuit boards, in each of which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers; and a second flexible circuit board in which wiring layers are formed on both surfaces thereof; and performing heating-pressurization processing for connecting the wiring layers formed on the both surfaces of the second flexible circuit board to upper surfaces of the bumps of the two first flexible circuit boards and filling a space between the wiring layers of the second flexible circuit board with a thicker thermoplastic polyimide layer molten of each of the first flexible circuit boards.

### BEST MODE FOR CARRYING OUT THE INVENTION

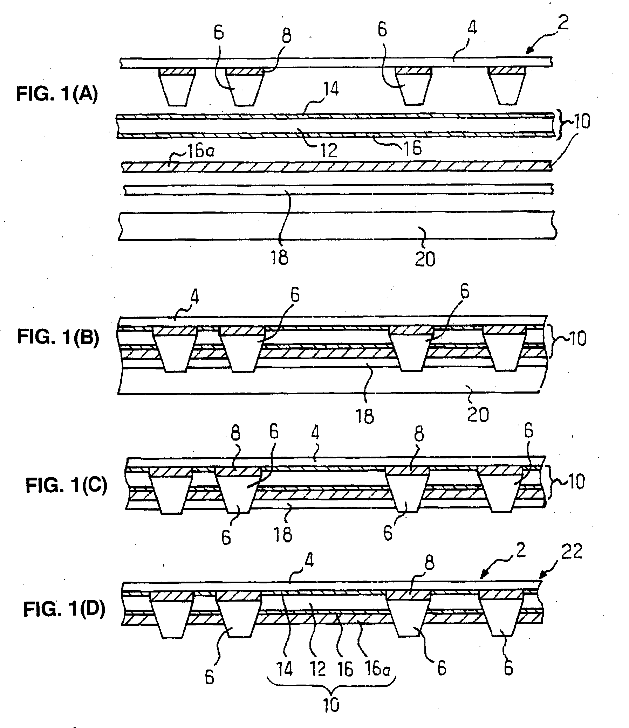

Hereinafter, the present invention will be described in detail with reference to shown embodiments. Figs. 1(A) to 1(D) are sectional views showing a method of manufacturing a flexible circuit board according to a first embodiment of the present invention in a step order. Steps will be described in the step order.

(A) A metal member 2 having bumps is prepared and a bump formation surface side thereof is opposed to an interlayer insulating film 10. Fig. 1(A) shows such a state. First, the metal member 2 will be described. Reference numeral 4 denotes a copper layer (for example, 18 µm in thickness) which is selectively etched to become wiring films. Reference numeral 6 denotes bumps, each of which is made of copper or the like. The bumps are formed on one main surface of the copper layer 4 through an etching barrier layer 8 made of nickel or the like (for example, 1 µm in thickness) [bottom (base portion) diameter is, for example, 0.15 mm, minimum arrangement pitch is, for example, 0.5 mm, and height in this stage is, for example, 80 µm]. The bumps become interlayer connection means.

Reference numeral 10 denotes an interlayer insulating film. The interlayer insulating film includes a non-thermoplastic polyimide layer (for example, 20 µm in thickness) 12 corresponding to the core of the film, a bonding layer (for example, 2.5 µm in thickness) 14 which is a thermoplastic polyimide layer and formed on a surface of the non-thermoplastic polyimide layer 12 which is located on the metal member 2 side, and a bonding layer (for example, 2.5 µm in thickness) 16 which is a thermoplastic polyimide layer and formed on a surface of the non-thermoplastic polyimide layer 12 which is located on the opposite side of the metal member 2. The interlayer insulating film further includes a bonding layer (for example, 17 µm in thickness) 16a laminated on the bonding layer 16.

The reason why the bonding layer 16a is further laminated on the bonding layer 16 is to obtain a thickness required for bonding to the surface of the non-thermoplastic polyimide layer 12 which is located on the opposite side of the metal member 2. Another thermoplastic sheet is used because a coated layer having a thickness equal to a necessary thickness (for example, 2 to 3 µm) of the bonding layer 16 is easily available. Therefore, when a thermoplastic polyimide resin layer coated at an asymmetric thickness can be prepared, the bonding layer 16a is unnecessary.

Note that, when the flexible circuit board manufactured by this manufacturing method is to be laminated on another flexible circuit board, the necessary thickness is a thickness corresponding to a mass in which a gap between wiring films located on a surface of the other flexible circuit board can be sufficiently filled with the bonding layer by heat melting and pressurization flowing to laminate the two flexible circuit boards without gap. Reference numeral 18 denotes a protective film 18. Reference numeral 20 denotes a cushion material. The interlayer insulating film 10 to be located on the metal member 2 is subjected to pressurization and heating through the cushion material 20, so the cushion material 20 serves to protect a bump shape. The protective film 18 serves to protect the surface of the metal member 2 on which the interlayer insulating film 10 is laminated.

(B) Next, the interlayer insulating film 10 is pressurized and heated to be made in close contact with the metal member 2. Fig. 1 (B) shows a close contact state caused by the pressurization and heating.

(C) After that, the cushionmaterial 20 is removed and polishing is performed to expose the upper surface of each of the bumps 6. Fig. 1(c) shows a state after the polishing.

(D) Next, the protective film 18 is removed. Fig. 1 (D) shows a state after the removal of the protective film 18. Therefore, a flexible circuit board 22 according to the first embodiment of the present invention is completed.

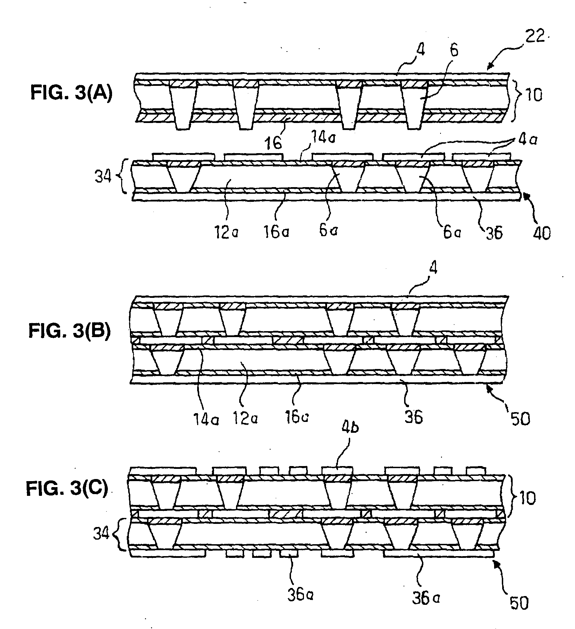

When the flexible circuit board 22 is laminated on a flexible circuit board (40) (see Fig. 3) to produce a flexible multi-layer wiring circuit board (50) (see Fig. 3), a total thickness of the bonding layers 16 and 16a (see Fig. 1(D)), each of which is made of a thermoplastic polyimide resin and located on the opposite side of the metal member 2 of the interlayer insulating film 10 is a thickness corresponding to a mass with which a space between wiring films (4a, 4a) (see Fig. 3) located on a surface connected to the bumps 6 can be sufficiently filled. Therefore, the gap [see a portion indicated by reference numeral 134 in Fig. 5(B)] is not caused. In addition, a sectional structure of a wiring board in the up-and-down direction, the thermoplastic polyimide layers, the non-thermoplastic polyimide layers, and the wiring films become substantially symmetric with respect to the wiring film 4a (see Fig. 3). Therefore, it is possible to provide a flexible multi-layer wiring circuit board having less warp.

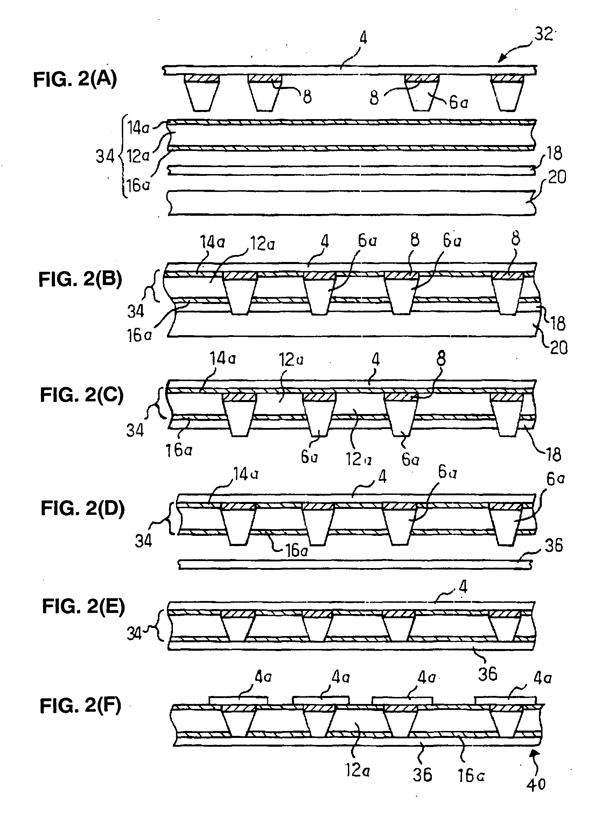

Figs. 2(A) to 2(F) are sectional views showing a method of manufacturing an example of the flexible circuit board (40) on which the flexible circuit board 22 is laminated in step order. Steps will be described in the step order.

(A) For example, a metal member 32 having the same structure as that of the metal member 2 shown in Fig. 1 is prepared. The structure and the manufacturing method are described above, so the descriptions are omitted here. Note that each of bumps 6a of the metal member 32 has a height slightly lower than a height (for example, 80 µm) of each of the bumps 6 of the flexible circuit board 22 shown in Fig. 1(D), which is, for example, about 60 µm.

Then, a bump formation surface of the metal member 32 is opposed to an interlayer insulating film 34 in which thermoplastic polyimide resin layers (for example, about 2.5 µm in thickness) 14a and 16a are formed on both surfaces of a non-thermoplastic polyimide resin layer (for example, about 20 µm in thickness) 12a such that pressurization and heating through the protective film 18 and the cushion material 20 can be performed for bonding. Fig. 2(A) shows an opposed state.

The interlayer insulating film 34 which is to be in contact with the metal member 32 and in which the thermoplastic polyimide resin layers (for example, about 2.5 µm in thickness) 14a and 16a are formed on both surfaces of the non-thermoplastic polyimide resin layer (for example, about 20 µm in thickness) 12a has, for example, the same structure as that of the interlayer insulating film 112 of the conventional flexible circuit board 100 shown in Fig. 5, a two-layer structure. Of course, the thicknesses of the thermoplastic polyimide resin layers 14a and 16a formed on both surfaces of the non-thermoplastic polyimide resin layer 12, which is made as the core are equal to each other and thus the bonding layer 16a located on the opposite side of the copper layer is not made thicker than the bonding layer 14a located on the copper layer side.

(B) Next, the interlayer insulating film 32 is made in close contact with the metal member 32 by pressurization and heating. Fig. 2 (B) shows a close contact state caused by the pressurization and heating.

(C) After that, the cushionmaterial 20 is removed and polishing is performed to expose the upper surface of each of the bumps 6a. Fig. 2(c) shows a state after the polishing.

(D) Next, the protective film 18 is removed. A surface of the metal member 32 from which the protective film 18 is removed is opposed to a copper layer 36 which is selectively etched later to become wiring films and to be laminated on the surface thereof. Fig. 2(D) shows an opposed state of the copper layer 36.

(E) Next, as shown in Fig. 2(E), the copper layer 36 is laminated by pressurization and heating on a surface of the interlayer insulating film 34 of the metal member 32 on which the interlayer insulating film 34 is laminated so as to connect to the bumps 6a.

(F) Next, as shown in Fig. 2(F), the copper layer 4 (wiring layer to which the bumps 6a are formed) is selectively etched to form wiring films 4a. Therefore, the flexible circuit board 40 on which the flexible circuit board manufactured by the method shown in Fig. 1 is to be laminated is completed.

Figs. 3(A) to 3(C) are sectional views showing an example of a method of manufacturing a flexible multi-layer wiring circuit board (50) according to the first embodiment of the present invention in which the flexible circuit board 22 [see Fig. 1(D)] manufactured by the method shown in Fig. 1 is laminated on the flexible circuit board 40 [see Fig. 3(A)] manufactured by the method shown in Fig. 2 in step order. Steps will be described in the step order.

(A) As shown in Fig. 3(A), the flexible circuit board 22 and the flexible circuit board 40 are prepared. Alignment is performed such that a bump 6 formation surface (interlayer insulating film 34 formation surface) of the flexible circuit board 22 faces a wiring film 4a formation surface of the flexible circuit board 40 and the bumps 6 are fit to the corresponding wiring films 4a. Therefore, the flexible circuit board 22 is opposed to the flexible circuit board 40.

(B) Next, as shown in Fig. 3(B), the flexible circuit board 22 is pressurized to the flexible circuit board 40 and heated to connect the respective bumps 6 to the corresponding wiring films 4a. Then, in addition to this, the bonding layers 16 and 16a of the interlayer insulating film 10 of the flexible circuit board 22 are inserted into a space between the respective wiring films 4a, 4a by heating because of the plasticity and the space is filled therewith. Therefore, the two flexible circuit boards 22 and 40 become a state in which they are rigidly laminated without any gap therebetween. Thus, it is possible to complete the flexible multi-layer wiring circuit board 50 in which the flexible circuit board 22 is laminated on the flexible circuit board 40.

(C) After that, the copper layers 4 and 36 on both surfaces of the flexible multi-layer wiring circuit board 50 are selectively etched to form wiring films 4b and 36a as shown in Fig. 3(C).

As described above, in the flexible multi-layer wiring circuit board 50 shown in Fig. 3, the bonding layers 16 and 16a of the interlayer insulating film 10 of the flexible circuit board 22 which are located on the opposite side of the copper layer 4 are thicker than the wiring films 4b of the flexible circuit board 40 which are connected to the bumps 6. When the flexible circuit board 22 is to be laminated on the flexible circuit board 40 by pressurization and heating, the molten bonding layers are inserted into a space between the respective wiring films 4a, 4a of the flexible circuit board 40 and the gap is filled therewith. Therefore, the two flexible circuit boards 22 and 40 become a state in which they are rigidly laminated without any gap [see the portion indicated by reference numeral 134 in Fig. 5(B)] therebetween. Thus, it is possible to provide the flexible multi-layer wiring circuit board 50 which is not deteriorated by the gap. In addition, a sectional structure in the up-and-down direction becomes substantially symmetric (axisymmetric) about the copper wiring films 4a, so that a flexible multi-layer wiring circuit board having less warp is obtained.

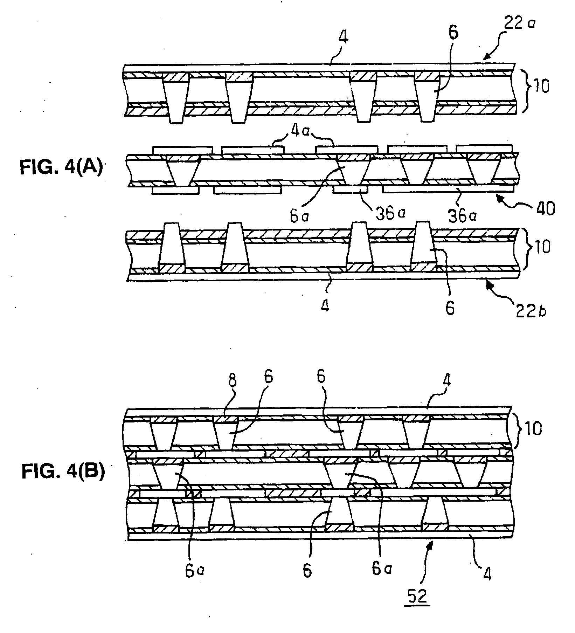

Figs. 4 (A) and 4 (B) are sectional views showing a method of preparing the flexible circuit board 40 [see Fig. 3(A)] manufactured by the method shown in Fig. 2 in which the copper layer 36 for wiring film formation is patterned to form wiring films 36a and laminating the flexible circuit board 22 [see Fig. 1(D)] manufactured by the method shown in Fig. 1 on both surfaces of the flexible multi-layer wiring circuit board 40 to manufacture a flexible multi-layer wiring circuit board 52 (method of manufacturing a flexible multi-layer wiring circuit board according to a second embodiment of the present invention) in step order. Steps will be described in the step order.

(A) As shown in Fig. 4(A), one flexible circuit board 40 and two flexible circuit boards 22a (upper flexible circuit board) and 22b (lower flexible circuit board) are prepared. The flexible circuit board 40 having not the state shown in Fig. 2(F) but a state in which the copper layer 36 in the state shown in Fig. 2(F) is patterned to form the wiring films 36a is prepared. This is because it is necessary to form the wiring films 36a by patterning before lamination.
In contract to this, the flexible circuit boards 22a and 22b, each of which has the state shown in Fig. 1(D) is prepared.

Alignment is performed such that the bump 6 formation surfaces (interlayer insulating film 10 formation surfaces) of the flexible circuit boards 22a and 22b face the wiring film (4a and 36a) formation surfaces of the flexible circuit board 40 which are both surfaces thereof and the bumps 6 are fit to the corresponding wiring films 4a and 36a. Therefore, the flexible circuit boards 22a and 22b are opposed to both the surfaces of the flexible circuit board 40. Fig. 4(A) shows an opposed state.

(B) Next, as shown in Fig. 4(B), the flexible circuit boards 22a and 22b are pressurized to both the surfaces of the flexible circuit board 40 and heated to connect the respective bumps 6 to the corresponding wiring films 4a and 36a. Then, in addition to this, the bonding layers 16 and 16a (see Fig. 1) of the interlayer insulating films 10 of the flexible circuit boards 22a and 22b are melted and inserted into spaces between the respective wiring films 4a, 4a and 36a, 36a by heating because of the plasticity and the spaces are filled therewith. Therefore, the two flexible circuit boards 22a and 22b and the flexible circuit board 40 become a state in which they are rigidly laminated without any gap therebetween. Thus, it is possible to complete the flexible multi-layer wiring circuit board 52 in which the flexible circuit boards 22a and 22b are laminated on the flexible circuit board 40.

After that, the copper layers 4 on both surfaces of the flexible multi-layer wiring circuit board 52 are selectively etched to form wiring films (not shown) . Therefore, according to this embodiment, it is possible to provide the flexible multi-layer wiring circuit board 52 in which the number of layers is larger than that in the embodiment shown in Fig. 3 and the degree of warp caused by the gap is less as in the embodiment shown in Fig. 3. In addition, according to this embodiment, when the flexible circuit board 40 is located at the center in the up-and-down direction, a sectional structure in the up-and-down direction becomes substantially symmetric (axisymmetric), so that the flexible multi-layer wiring circuit board 52 having less warp is obtained.

### INDUSTRIAL APPLICABILITY

According to a flexible circuit board in claim 1, a bonding layer of an interlayer insulating film which is located on an opposite side of the metal member is thickened. Therefore, when a flexible multi-layer wiring circuit board is produced by lamination on another flexible circuit board, a flowing bonding layer having a mass enough to fill spaces between wiring films located on a surface connected to bumps can be obtained because the mass of the bonding layer is large. Thus, it is possible to provide a flexible multi-layer wiring circuit board having no gap and less warp.

According to a method of manufacturing a flexible circuit board in claim 2, a metal member in which a plurality of bumps are formed is prepared and an interlayer insulating film in which thermoplastic polyimide layers as bonding agents which have thicknesses different from each other and are formed on both surface of a non-thermoplastic polyimide layer is pressurization-bonded to a bump formation surface of the metal member such that each of the bumps passes through the interlayer insulating film in a direction in which a thinner thermoplastic polyimide layer faces the bump formation surface. Therefore, the flexible circuit board according to claim 1 can be obtained.

According to a flexible multi-layer wiring circuit board in claim 3, the flexible circuit board according to claim 1 is laminated on another flexible circuit board such that the bumps are connected to wiring films located on a surface of the other flexible circuit board. In addition, as described above, the bonding layer of the interlayer insulating film of the flexible circuit board according to claim 1, which is located on the opposite side of the metal member is thickened and the bonding layer thereof is made thicker than wiring films of the other flexible circuit board to be laminated to itself, so a gap can be prevented from being caused between the flexible circuit boards. Therefore, it is possible to prevent a reduction in reliability resulting from, for example, the warp of the flexible multi-layer wiring circuit which is caused by the gap.

According to a method of manufacturing a flexible multi-layer wiring circuit board in claim 4, a flexible circuit board (first flexible circuit board) according to claim 1 and another flexible circuit board (second flexible circuit board) are laminated on the other flexible circuit board (second flexible circuit board) such that the bumps of the flexible circuit board (first flexible circuit board) according to claim 1 are connected to wiring films on surfaces of the other flexible circuit board (second flexible circuit board) . Therefore, it is possible to obtain a flexible multi-layer wiring circuit board according to claim 3.

According to a flexible multi-layer wiring circuit board in claim 5, two flexible circuit boards (first flexible circuit boards) according to claim 1 and another flexible circuit board (second flexible circuit board) are laminated on the other flexible circuit board (second flexible circuit board) such that the bumps of the flexible circuit boards (first flexible circuit boards) according to claim 1 are connected to wiring films on surfaces of the other flexible circuit board (second flexible circuit board). Therefore, it is possible to obtain a flexible multi-layer wiring circuit board having the number of layers larger than that of the flexible multi-layer wiring circuit board according to claim 3.

In addition, the bonding layer of the interlayer insulating film of the flexible circuit board according to claim 1, which is located on the opposite side of the metal member is thickened and the bonding layer thereof is made thicker than the wiring films of the other flexible circuit board laminated (second flexible circuit board), so a gap can be prevented from being caused between the first and second flexible circuit boards. Therefore, there provides an effect that it is possible to prevent a reduction in reliability resulting from, for example, the warp of the flexible multi-layer wiring circuit which is caused by the gap.

### BRIEF DESCRIPTION OF THE DRAWINGS

[Fig. 1(A)], [Fig. 1(B)], [Fig. 1(C)], and [Fig. 1(D)]
   Sectional views showing a method of manufacturing a flexible circuit board according to a first embodiment of the present invention in step order.
[Fig. 2 (A)], [Fig. 2 (B)], [Fig. 2 (C)], [Fig. 2 (D)], [Fig. 2 (E)] and [Fig. 2(F)] Sectional views showing a method of manufacturing another flexible circuit board on which the flexible circuit board according to the first embodiment of the present invention which is to be manufactured by the method shown in Fig. 1 is laminated in step order.
[Fig. 3(A)], [Fig. 3(B)] and [Fig. 3(C)] Sectional views showing a method of manufacturing a flexible multi-layer wiring circuit board according to the first embodiment of the present invention in which the flexible circuit board according to the first embodiment of the present invention which is manufactured by the method shown in Fig. 1 is laminated on the flexible circuit board manufactured by the method shown in Fig. 2 in step order.
[Fig. 4(A)] and [Fig. 4(B)] Sectional views showing a method of manufacturing a flexible four-layer wiring circuit board according to a second embodiment of the present invention in which the flexible circuit board according to the first embodiment of the present invention which is manufactured by the method shown in Fig. 1 is laminated on the flexible circuit board manufactured by the method shown in Fig. 2 in step order.
[Fig. 5(A)] and [Fig. 5(B)] Sectional views showing a method of manufacturing a flexible multi-layer wiring circuit board according to a conventional example in step order.

## Claims

1. A flexible circuit board, comprising:
a plurality of bumps which are directly formed on a surface portion of one of a wiring layer and a metal layer for wiring layer formation or formed thereon through an etching barrier layer, each of the bumps having an upper surface connected to a wiring film of another flexible circuit board; and
an interlayer insulating film including a non-thermoplastic polyimide layer and thermoplastic polyimide layers as bonding agents which are formed on both surface thereof, the interlayer insulating film being provided in a portion in which the bumps are not formed on a bump formation surface of the one of the wiring layer and the metal layer for wiring layer formation,
wherein one of the thermoplastic polyimide layers of the interlayer insulating film which is located on an opposed side of the one of the wiring layer and the metal layer for wiring layer formation is thicker than the other of the thermoplastic polyimide layers.

2. A method of manufacturing a flexible circuit board, comprising:
preparing one of a wiring layer and a metal layer for wiring layer formation in which a plurality of bumps are directly formed on a surface portion thereof or formed thereon through an etching barrier layer; and
pressurization-bonding an interlayer insulating film in which thermoplastic polyimide layers as bonding agents which have thicknesses different from each other and are formed on both surface of a non-thermoplastic polyimide layer to a bump formation surface of the one of the wiring layer and the metal layer for wiring layer formation such that each of the bumps passes through the interlayer insulating film in a direction in which a thinner thermoplastic polyimide layer faces the bump formation surface.

3. A flexible multi-layer wiring circuit board comprising: a flexible circuit board in which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers; and an another flexible circuit board different from the flexible circuit board, in which wiring layers are formed on at least one main surface, at least a part of each of the wiring layers is connected to an upper surface of each of the bumps, and a space between the wiring layers on the one main surface is filled with a thicker thermoplastic polyimide layer molten.

4. A method of manufacturing a flexible multi-layer wiring circuit board, comprising:
preparing:
a first flexible circuit board in which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers; and
a second flexible circuit board in which wiring layers are formed on at least one main surface thereof; and
performing heating-pressurization processing for connecting at least a part of each of the wiring layers formed on the one main surface of the second flexible circuit board to an upper surface of each of the bumps and filling a space between the wiring layers on the one main surface with a thicker thermoplastic polyimide layer molten.

5. A method of manufacturing a flexible multi-layer wiring circuit board, comprising:
preparing:
two first flexible circuit boards, in each of which a plurality of bumps are directly formed on a surface portion of one of a wiring layer and a metal layer for wiring layer formation or formed thereon through an etching barrier layer, an interlayer insulating film in which thermoplastic polyimide layers as bonding agents are formed on both surface of a non-thermoplastic polyimide layer is provided in a portion in which the bumps are not formed on a bump formation surface of the one of the wiring layer and the metal layer for wiring layer formation, and one of the thermoplastic polyimide layers of the interlayer insulating film which is located on an opposed side of the one of the wiring layer and the metal layer for wiring layer formation is thicker than the other of the thermoplastic polyimide layers and
a second flexible circuit board in which wiring layers are formed on both surfaces thereof; and
performing heating-pressurization processing for connecting the wiring layers formed on the both surfaces of the second flexible circuit board to upper surfaces of the bumps of the two first flexible circuit boards and filling a space between the wiring layers of the second flexible circuit board with a thicker thermoplastic polyimide layer of each of the first flexible circuit boards.
